# EUROPEAN PATENT APPLICATION

(11) **EP 4 564 441 A1**
(43) Date of publication of application: **04.06.2025**
(21) Application number: 23845187.6
(22) Date of filing: 28.06.2023
(51) Int. Cl.: H01L 31/18, B23K 37/00

(54) **LAYOUT AND STITCH WELDING MACHINE**

(30) Priority: 27.07.2022 CN 202210889417
(71) Applicant: Wuxi Autowell Technology Co., Ltd., Wuxi, Jiangsu 214000 (CN)
(72) Inventor: WANG, Heng, Wuxi, Jiangsu 214000 (CN); SHEN, Bo, Wuxi, Jiangsu 214000 (CN); LI, Tingbiao, Wuxi, Jiangsu 214000 (CN); ZHAO, Mi, Wuxi, Jiangsu 214000 (CN)
(74) Representative: Winter, Brandl - Partnerschaft mbB
(86) International application number: PCT/CN2023/103269
(87) International publication number: WO 2024/021974

(57) **Abstract**

The present disclosure provides a layup and bussing machine, comprising a layup pickup portion, an alignment and conveying portion, a bussing pickup portion and a bussing portion, wherein the layup pickup portion is configured to place a cell string on the alignment and conveying portion; the alignment and conveying portion is configured to align the cell string; the bussing pickup portion comprises string pickup assemblies corresponding to cell strings in a cell string array on a one-to-one basis; the alignment and conveying portion is further configured to convey the aligned cell string to a string pickup station, and the bussing pickup portion drives a string pickup assembly corresponding to the cell string at the string pickup station to move to the string pickup station for picking up the cell string; the bussing pickup portion moves to drive the string pickup assembly, which has picked up the cell string, to a soldering station, and the bussing portion solders a busbar to marginal solder strips of the cell string located at the soldering station; and the bussing pickup portion is further configured to lay the cell strings, which are picked up by the string pickup assemblies and have completed the busbar soldering, on a glass plate. The layup and bussing machine provided by the present disclosure greatly decreases the number of times of gripping and placing the cell strings, and can effectively reduce a fragmentation rate.

## Description

### Technical Field

The present disclosure relates to the field of cell production, and in particular, to a layup and bussing machine.

### Background Art

Photovoltaic modules are generally manufactured by packaging upper and lower glass plates and a cell string array located between the upper and lower glass plates. When the photovoltaic modules are being manufactured, it is necessary to lay up cell strings produced by a soldering stringer according to the requirements for a cell string array, and to perform bussing on marginal solder strips of the cell strings. Currently, it is necessary to grip and place the cell strings multiple times during the layup and bussing of the cell strings. For example, during the layup, it is necessary for a gripper to grip and place the cell strings on a positioning table for layup, and then grip and place all the cell strings subjected to layup on the glass plate for output. During the bussing, it is necessary for the gripper to grip and place all the cell strings on the glass plate to an alignment table for alignment, then grip and place all the aligned cell strings from the alignment table for busbar soldering, and place the cell strings back to the glass plate after the soldering is completed. During the aforementioned layup and bussing, the cell strings are gripped and placed up to four times. However, frequent gripping and placement of the cell strings are the main cause of cell fragmentation. Therefore, it is especially important to decrease the number of times of gripping and placing the cell strings during the layup and bussing.

### Summary of the Disclosure

In order to solve the aforementioned technical problem, the present disclosure provides a layup and bussing machine, and the detailed technical solution thereof will be described as follows.

A layup and bussing machine, which is configured to perform layup and busbar soldering on cell strings according to a cell string array in a photovoltaic module, comprises a layup pickup portion, an alignment and conveying portion, a bussing pickup portion and a bussing portion.

The layup pickup portion is arranged upstream of the alignment and conveying portion, and the layup pickup portion is configured to pick up a cell string and place the cell string on the alignment and conveying portion according to layup requirements for positive and negative electrodes.

The alignment and conveying portion is configured to receive and align the cell string placed by the layup pickup portion.

The bussing pickup portion comprises string pickup assemblies arranged in one-to-one correspondence with the cell strings of the cell string array. The alignment and conveying portion is further configured to convey the aligned cell string to a string pickup station according to layup position requirements, and the bussing pickup portion moves to drive a string pickup assembly corresponding to the cell string at the string pickup station to move to the string pickup station for picking up the cell string.

The bussing pickup portion moves to drive the string pickup assembly, which has picked up the cell string, to a soldering station, and the bussing portion solders a busbar to marginal solder strips of the cell string located at the soldering station.

The bussing pickup portion is further configured to move so as to lay the cell strings picked up by the string pickup assemblies on a glass plate after the soldering of the busbar to the cell strings picked up by the string pickup assemblies is completed.

According to the layup and bussing machine provided by the present disclosure, the layup pickup portion first places a cell string on the alignment and conveying portion according to the layup requirements for positive and negative electrodes, the alignment and conveying portion then aligns the cell string according to the layup position requirements and conveys the aligned cell string to the string pickup station, the bussing pickup portion picks up the cell string from the string pickup station and then conveys the cell string to the soldering station, and the bussing portion solders the busbar directly to the cell string on the bussing pickup portion. The bussing pickup portion lays all the cell strings on the glass plate after the soldering of all the busbars is completed. At this point, the layup and the busbar soldering of one cell string array are completed.

It can be seen that the layup and bussing machine provided by the present disclosure grips and places the cell strings only twice in the entire layup and bussing process, that is, once by means of the layup pickup portion and once by means of the bussing pickup portion, thus greatly decreasing the number of times of gripping and placing the cell strings, so that the fragmentation rate of cells in the layup and bussing process can be effectively reduced.

**In** some embodiments, the layup pickup portion places at least one module unit on the alignment and conveying portion at a predetermined time interval, each module unit comprising two cell strings arranged in line in a length direction of the cell strings, and a plurality of module units being arranged side by side in a width direction of the cell strings to form the cell string array; the alignment and conveying portion conveys an aligned module unit to the string pickup station at a predetermined time interval; and the bussing pickup portion moves in a downstream direction by a predetermined distance at a predetermined time interval, so as to drive the string pickup assembly corresponding to the module unit at the string pickup station to the string pickup station for picking up the module unit, while driving the string pickup assembly, which has already picked up a module unit, to the soldering station.

In this embodiment, by dividing an entire cell string array into a plurality of module units, and performing layup pickup, alignment and conveying, bussing pickup and busbar soldering on at least one module unit each time, the layup pickup portion places the cell strings in the form of a module unit on the alignment and conveying portion each time. Correspondingly, the alignment and conveying portion conveys the aligned module unit to the string pickup station each time; and the bussing pickup portion moves in the downstream direction by the predetermined distance each time, so as to drive the string pickup assembly corresponding to the module unit at the string pickup station to the string pickup station for picking up the module unit currently located at the string pickup station, and to drive the string pickup assembly, which has already picked up a module unit previously, to the soldering station, and the bussing portion solders the busbar to the module unit at the soldering station each time. These operations are cyclically repeated in this way until the pickup and busbar soldering of one cell string array are completed on the bussing pickup portion, and then the cell string array can be discharged onto the glass plate.

It can be seen that the alignment and conveying portion aligns and conveys at least one module unit each time, instead of waiting for all the module units in the cell string array to be aligned before conveying; and the bussing portion solders the at least one module unit conveyed in place each time, instead of waiting for all the module units to be in place before soldering. Therefore, in this embodiment, structures of the alignment and conveying portion and the bussing portion can be simplified, equipment costs can be reduced, the area occupied by the equipment can be reduced, and the efficiency of layup and busbar soldering can be improved.

In some embodiments, the layup pickup portion comprises a movement mechanism, a rotating mechanism and a pickup assembly, wherein the rotating mechanism is connected to a driving end of the movement mechanism, and the pickup assembly is mounted on the rotating mechanism; the movement mechanism is configured to drive the pickup assembly to translate and lift so as to pick up a cell string; the rotating mechanism is configured to drive the pickup assembly to rotate so as to rotate the cell string until the layup requirements for positive and negative electrodes are met; and the movement mechanism is further configured to drive the pickup assembly to translate and lift so as to place the picked-up cell string on the alignment and conveying portion.

A layup pickup portion with a simple structure is provided, such that the layup pickup portion drives the pickup assembly to move and rotate by means of the cooperation of the movement mechanism and the rotating mechanism, thereby rotating and then placing the cell string on the alignment and conveying portion according to the layup requirements for positive and negative electrodes.

In some embodiments, two layup pickup portions are provided, which are a first layup pickup portion and a second layup pickup portion, respectively, wherein the first layup pickup portion is configured to place one of the cell strings of the module unit on the alignment and conveying portion, and the second layup pickup portion is configured to place the other cell string in the module unit on the alignment and conveying portion.

By providing the first layup pickup portion and the second layup pickup portion, synchronous gripping and placement of the two cell strings of the module unit are achieved, and the layup efficiency of the module unit can be improved effectively.

In some embodiments, the alignment and conveying portion comprises a first alignment and conveying mechanism and a second alignment and conveying mechanism which are of the same structure, wherein the first alignment and conveying mechanism and the second alignment and conveying mechanism are arranged in line in a first horizontal direction; the first alignment and conveying mechanism and the second alignment and conveying mechanism are respectively configured to carry the two cell strings of the module unit; the first alignment and conveying mechanism comprises a first translation drive mechanism and at least one alignment platform connected to a movable end of the first translation drive mechanism, wherein the alignment platform is configured to carry one cell string and align the cell string; and the first translation drive mechanism is configured to drive the alignment platform to translate in a second horizontal direction perpendicular to the first horizontal direction, so as to convey the cell string carried on the alignment platform to the string pickup station.

By providing the first alignment and conveying mechanism and the second alignment and conveying mechanism, the synchronous alignment and conveying of the two cell strings of the module unit are achieved.

In some embodiments, the alignment platform comprises a second translation drive mechanism, a lifting drive mechanism, a rotation drive mechanism and an alignment carrying plate, wherein the second translation drive mechanism is connected to the movable end of the first translation drive mechanism, the lifting drive mechanism is connected to a movable end of the second translation drive mechanism, the rotation drive mechanism is connected to a movable end of the lifting drive mechanism, and the alignment carrying plate is connected to a movable end of the rotation drive mechanism; and the alignment carrying plate is configured to carry the cell string, the second translation drive mechanism is configured to drive the alignment carrying plate to translate in the first horizontal direction, the lifting drive mechanism is configured to drive the alignment carrying plate to lift, and the rotation drive mechanism is configured to drive the alignment carrying plate to rotate in a horizontal plane.

An alignment platform with a simple structure is provided, such that by means of the cooperative driving of the first translation drive mechanism, the second translation drive mechanism and the rotation drive mechanism, the alignment carrying plate can be driven to implement the translation in the first horizontal direction and the second horizontal direction and the rotation in the horizontal directions, and accordingly it is possible to align the position of the cell string placed on the alignment carrying plate, and convey the aligned cell string to the string pickup station according to the layup position requirements. The lifting drive mechanism can drive the alignment carrying plate to ascend after the alignment platform moves to the string pickup station, so as to transfer the cell string to the corresponding string pickup assembly on the bussing pickup portion.

In some embodiments, the bussing pickup portion further comprises a stepping drive mechanism and a first mounting bracket, wherein the first mounting bracket is connected to a movable end of the stepping drive mechanism, and the string pickup assemblies are jointly mounted on the first mounting bracket; and the stepping drive mechanism is configured to drive, in a stepping manner, the string pickup assemblies to translate, so as to drive the string pickup assembly corresponding to a module unit at the string pickup station to the string pickup station for picking up the module unit, while driving the string pickup assembly, which has already picked up a module unit, to the soldering station.

The stepping drive mechanism performs stepping on the string pickup assemblies, so that the string pickup assemblies can sequentially step the module units conveyed by the alignment and conveying portion from the string pickup station to the soldering station until a plurality of module units soldered with the busbars form a cell string array.

In some embodiments, the layup and bussing machine further comprises a cell string supply portion, wherein the cell string supply portion is configured to produce a cell string and provide the produced cell string to the layup pickup portion.

By providing the cell string supply portion, automatic supply of the cell string is achieved.

In some embodiments, the cell string supply portion comprises a soldering stringer, a discharge conveyor line, a turnover mechanism and a temporary storage mechanism, wherein the soldering stringer is configured to produce a cell string; the discharge conveyor line is configured to output the cell string produced by the soldering stringer; the temporary storage mechanism is arranged on a side of the discharge conveyor line, and the turnover mechanism is configured to pick up the cell string from the discharge conveyor line, turn over the picked-up cell string by 180° and then place the cell string on the temporary storage mechanism; and the layup pickup portion picks up the cell string from the temporary storage mechanism.

By providing the turnover mechanism, the turnover of the cell string is achieved, the cell string is thus directly turned over to reach a state in which the cell string is to be subjected to layup, and the pickup efficiency of the layup pickup portion on the downstream side is then improved. By providing the temporary storage mechanism, the temporary storage of the cell string is achieved, to avoid waiting for layup caused by the inconsistency between the production speed of the soldering stringer and the layup pickup speed on the downstream side. In addition, the turnover mechanism can pick up and turn over the cell string and then place the cell string directly on the temporary storage mechanism, without the need for an additional cell string gripper which picks up the turned-over cell string and then places the cell string on the temporary storage mechanism. The turnover and temporary storage of the cell string can be achieved by means of a single gripping and placement, facilitating the reduction of the fragmentation rate of the cells.

In some embodiments, the cell string supply portion further comprises an EL testing mechanism, the EL testing mechanism is arranged on the discharge conveyor line and is configured to test the cell string output by the discharge conveyor line, and the turnover mechanism is configured to pick up the cell string that has passed the test carried out by the EL testing mechanism from the discharge conveyor line.

By providing the EL testing mechanism, the quality test of the cell strings is achieved, so that only the cell string that has passed the test can undergo the subsequent layup and soldering processes, and ultimately the pass rate of the photovoltaic module is ensured. Moreover, the EL testing mechanism is arranged directly on the discharge conveyor line, and can directly perform an EL test on the cell string on the discharge conveyor line, so that it is not necessary to grip the cell string away from the discharge conveyor line for testing, to avoid the gripping and placement of the cell string, facilitating the reduction of the fragmentation rate of the cells.

In some embodiments, the EL testing mechanism comprises a first activation mechanism and a second activation mechanism which are arranged on the discharge conveyor line in a conveying direction of the discharge conveyor line, and an EL camera arranged above or below the discharge conveyor line; the first activation mechanism and the second activation mechanism are configured to activate the cell string located on the discharge conveyor line from two ends; and the EL camera is configured to acquire an infrared image of the activated cell string so as to test the cell string.

An EL testing mechanism with a simple structure is provided, such that by providing the first activation mechanism and the second activation mechanism on the discharge conveyor line, the EL test can be completed while the cell string is kept on the discharge conveyor line, without the need to pick up the cell string from the discharge conveyor line.

In some embodiments, the turnover mechanism comprises a first lifting drive module, a second lifting drive module, a turnover motor, and a turnover suction assembly, wherein the turnover motor is connected to a driving end of the second lifting drive module; a first end of the turnover suction assembly is connected to a driving end of the first lifting drive module, and a second end of the turnover suction assembly is connected to a driving end of the turnover motor; and the first lifting drive module and the second lifting drive module cooperate with each other to drive the turnover suction assembly to lift, and the turnover motor is configured to drive the turnover suction assembly to be turned over between the discharge conveyor line and the temporary storage mechanism, so as to drive the turnover suction assembly to suck the cell string from the discharge conveyor line and turn over the sucked cell string to the temporary storage mechanism.

A turnover mechanism with a simple structure is provided, such that the cell string is directly turned over to reach the state in which the cell string is to be subjected to layup, by means of the cooperation of the first lifting drive module, the second lifting drive module, the turnover motor and the turnover suction assembly.

In some embodiments, the temporary storage mechanism comprises a second mounting bracket, a plurality of carriers, a first carrier pushing mechanism and a second carrier pushing mechanism, wherein the plurality of carriers are stacked on the second mounting bracket in a vertical direction, and each carrier is connected to the second mounting bracket via a slide rail; the first carrier pushing mechanism is configured to push one carrier out of the second mounting bracket toward a first side each time, so as to receive the cell string transferred by the turnover mechanism; and the second carrier pushing mechanism is configured to push one carrier carrying the cell string out of the second mounting bracket toward a second side each time, so as to provide the cell string to the layup pickup portion.

The second mounting bracket is provided with a plurality of carriers layer by layer, thereby achieving temporary storage of a plurality of cell strings. The carriers can each extend out or retract from two sides of the second mounting bracket. When extending out toward the first side, the carrier can receive the cell string transferred by the turnover mechanism, and when extending out toward the second side, the carrier can provide the cell string to the layup pickup portion, so that the temporary storage and takeout of cell strings can be performed on the two sides without interfering with each other.

In some embodiments, the bussing portion comprises a busbar preparation portion, a busbar handling portion, a busbar carrying portion and a soldering portion; the busbar preparation portion is configured to prepare a busbar; the busbar handling portion is configured to handle the busbar to the busbar carrying portion; the busbar carrying portion is configured to move the busbar to the position of a corresponding marginal solder strip; and the soldering portion is configured to solder the busbar carried by the busbar carrying portion to the marginal solder strip.

The busbar preparation portion achieves the preparation of the busbar, the busbar handling portion achieves the handling of the busbar from the preparation portion to the busbar carrying portion, the provision of the busbar carrying portion achieves the carrying, movement, and soldering support of the busbar, and the soldering portion achieves the soldering of the busbar to the marginal solder strips. When the busbar carrying portion and the soldering portion cooperate with each other to solder the busbar, the busbar preparation portion and the busbar handling portion can prepare and handle a busbar simultaneously, so that the efficiency is improved.

In some embodiments, the layup and bussing machine further comprises a glass plate conveyor line, wherein the glass plate conveyor line is arranged below the alignment and conveying portion and the bussing portion and has the same conveying direction as the alignment and conveying portion, and the glass plate conveyor line is configured to convey a glass plate to a discharging station downstream of the soldering station; and after the soldering of the busbar to the cell strings picked up by the string pickup assemblies is completed, the bussing pickup portion discharges the cell strings picked up by the string pickup assemblies onto the glass plate at the discharging station.

The online supply of the glass plate is achieved by providing the glass plate conveyor line, so as to receive the cell string discharged from the bussing pickup portion, facilitating the production in subsequent processes.

### Brief Description of the Drawings

FIG. 1 is a schematic structural diagram of a layup and bussing machine according to an embodiment of the present disclosure from a first perspective;
FIG. 2 is a schematic structural diagram of the layup and bussing machine according to the embodiment of the present disclosure from a second perspective;
FIG. 3 is a schematic structural diagram of the layup and bussing machine according to the embodiment of the present disclosure from a third perspective;
FIG. 4 is a schematic structural diagram of a first alignment and conveying mechanism according to an embodiment of the present disclosure;
FIG. 5 is a schematic structural diagram of a turnover mechanism, a temporary storage mechanism and an EL testing mechanism according to an embodiment of the present disclosure from one perspective;
FIG. 6 is a schematic structural diagram of the turnover mechanism, the temporary storage mechanism and the EL testing mechanism according to the embodiment of the present disclosure from another perspective;
FIG. 7 is a schematic structural diagram of a carrier according to an embodiment of the present disclosure;
FIG. 8 is a schematic structural diagram of a bussing portion according to an embodiment of the present disclosure; and
FIG. 9 is a schematic structural diagram of a cell string array after busbars are soldered according to an embodiment.

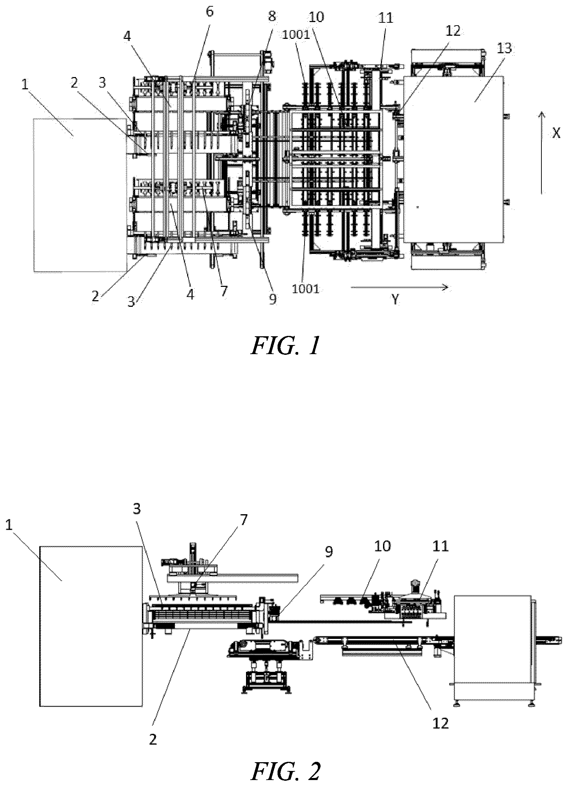

FIGS. 1 to 9 include reference signs as follows.
   Soldering stringer 1;
   Discharge conveyor line 2;
   Turnover mechanism 3: First lifting drive module 31, second lifting drive module 32, turnover motor 33, turnover suction assembly 34, rotating shaft 341, and suction member 342;
   Temporary storage mechanism 4: mounting bracket 41, carrier 42, first carrier pushing mechanism 43, second carrier pushing mechanism 44, and avoidance slot 421;
   EL testing mechanism 5: first activation mechanism 51, second activation mechanism 52, first electrode plate 511, first electrode plate driving portion 512, second electrode plate 521, and second electrode plate driving portion 522;
   First layup pickup portion 6;
   Second layup pickup portion 7;
   First alignment and conveying mechanism 8, and second alignment and conveying mechanism 9: first translation drive mechanism 81, slide rail 811, alignment platform 82, second translation drive mechanism 821, lifting drive mechanism 822, rotation drive mechanism 823, and alignment carrying plate 824;
   Bussing pickup portion 10: string pickup assembly 1001;
   Bussing portion 11: head busbar preparation sub-portion 111, middle and tail busbar preparation sub-portion 112, head busbar carrying sub-portion 113, tail busbar carrying sub-portion 114, middle busbar carrying sub-portion 115, head soldering sub-portion 116, middle soldering sub-portion 117, and tail soldering sub-portion 118;
   Glass plate conveyor line 12;
   Glass plate 13;
   First cell string 101, second cell string 102, third cell string 103, fourth cell string 104, fifth cell string 105, sixth cell string 106, seventh cell string 107, eighth cell string 108, ninth cell string 109, tenth cell string 110, eleventh cell string 111, and twelfth cell string 112;
   First middle busbar 201, first head busbar 202, first tail busbar 203, second middle busbar 204, second head busbar 205, second tail busbar 206, third middle busbar 207, third head busbar 208, fourth middle busbar 209, and third tail busbar 210.

### Detailed Description of Embodiments

In order to make the objectives, features and advantages of the present disclosure more clearly understood, the present disclosure will be further described in detail below with reference to the accompanying drawings and specific implementations.

The present disclosure provides a layup and bussing machine, which is configured to perform layup and busbar soldering on cell strings according to a cell string array in a photovoltaic module, and to pick up the cell strings only twice in the entire layup and bussing process, thereby effectively reducing a fragmentation rate.

As shown in FIGS. 1 to 3, the present disclosure provides a layup and bussing machine configured to perform layup and busbar soldering on cell strings according to a cell string array in a photovoltaic module. The layup and bussing machine comprises a layup pickup portion, an alignment and conveying portion, a bussing pickup portion 10, and a bussing portion 11.

The layup pickup portion is arranged upstream of the alignment and conveying portion, and the layup pickup portion is configured to pick up a cell string and place the cell string on the alignment and conveying portion according to layup requirements for positive and negative electrodes.

The alignment and conveying portion is configured to receive and align the cell string placed by the layup pickup portion.

The bussing pickup portion 10 comprises string pickup assemblies 1001 arranged in one-to-one correspondence with the cell strings of the cell string array. The alignment and conveying portion is further configured to convey the aligned cell string to a string pickup station according to layup position requirements, and the bussing pickup portion 10 moves to drive a string pickup assembly 1001 corresponding to the cell string at the string pickup station to move to the string pickup station for picking up the cell string.

The bussing pickup portion 10 moves to drive the string pickup assembly 1001, which has picked up the cell string, to a soldering station, and the bussing portion solders a busbar to marginal solder strips of the cell string located at the soldering station.

The bussing pickup portion is further configured to move so as to lay the cell strings picked up by the string pickup assemblies 1001 on a glass plate 13 after the soldering of the busbar to the cell strings picked up by the string pickup assemblies 1001 is completed.

It can be seen that, by using the layup and bussing machine of the present disclosure, the layup pickup portion first places a cell string on the alignment and conveying portion according to the layup requirements for positive and negative electrodes, the alignment and conveying portion then aligns the cell string according to the layup position requirements and conveys the cell string to the string pickup station, the bussing pickup portion picks up the cell string from the string pickup station and then conveys the cell string to the soldering station, and later, the bussing portion solders the busbar directly to the marginal solder strips at the end portions of the cell string staying on the bussing pickup portion. Since the string pickup assemblies on the bussing pickup portion are arranged in one-to-one correspondence with the cell strings of the cell string array, the layup of the cell strings is completed upon all the string pickup assemblies completing the pickup of the cell strings, and finally, the bussing pickup portion lays the cell strings on the glass plate after the busbars are soldered to all the cell strings picked up, that is, the layup and the busbar soldering of a photovoltaic module are completed.

In the entire layup and bussing process, the cell strings are gripped and placed only twice, so that the number of times of gripping and placing the cell strings is greatly decreased, and the fragmentation rate of cells in the layup and bussing process can be effectively reduced.

The photovoltaic modules may typically be classified into full-cell modules and half-cell modules. The full-cell module is manufactured by packaging a cell string array composed of a plurality of full cell strings, the half-cell module is manufactured by packaging a cell string array composed of a plurality of half-cut cell strings, and the half-cut cell string is formed by performing series soldering on small cell segments of a full cell cut off and has a length approximately half of the length of the full cell string. There are marginal solder strips at the end portions of the half-cut cell strings and the full cell strings, which are to be soldered to busbars, and the busbars can collect currents generated by the cell strings and output the currents by means of a junction box.

Typically, considering the overall design length of the module, the cell string array in the full-cell module only comprises one group of full cell strings, and the cell strings of the group of full cell strings are arranged side by side, such that the marginal solder strips in the full-cell module are located only at a head portion and a tail portion of the module. In contrary, the cell string array in the half-cell module comprises two groups of half-cut cell strings in order to obtain a length equivalent to that of the full-cell module, the two groups of half-cut cell strings are arranged in line in a length direction of the cell strings, and the cell strings of each group of half-cut cell strings are arranged side by side, such that the marginal solder strips in the half-cell module are located at a head portion, a middle portion and a tail portion of the module.

Compared with the full-cell modules, the half-cell modules exhibit more excellent photoelectric conversion efficiency. Therefore, the half-cell modules have attracted much attention and been highly favored in recent years.

With regard to the layup and busbar soldering of the aforementioned half-cell modules, an implementation of the present disclosure lies in that the layup pickup portion places at least one module unit on the alignment and conveying portion at a predetermined time interval, each module unit comprising two cell strings arranged in line in a length direction of the cell strings, and a plurality of module units being arranged side by side in a width direction of the cell strings to form the cell string array; the alignment and conveying portion conveys an aligned module unit to the string pickup station at a predetermined time interval; and the bussing pickup portion moves in a downstream direction by a predetermined distance at a predetermined time interval, so as to drive the string pickup assembly corresponding to the module unit at the string pickup station to the string pickup station for picking up the module unit, while driving the string pickup assembly, which has already picked up a module unit, to the soldering station.

By dividing the cell string array of the half-cell module into a plurality of module units, and performing layup pickup, alignment and conveying, bussing pickup and busbar soldering on at least one module unit each time, the layup pickup portion places the cell strings in the form of a module unit on the alignment and conveying portion each time. Correspondingly, the alignment and conveying portion conveys the aligned module unit to the string pickup station each time; and the bussing pickup portion moves in the downstream direction by the predetermined distance each time, so as to drive the string pickup assembly corresponding to the module unit at the string pickup station to the string pickup station for picking up the module unit currently located at the string pickup station, and to drive the string pickup assembly, which has already picked up a module unit previously, to the soldering station, and the bussing portion solders the busbar to the module unit at the soldering station each time. These operations are cyclically repeated in this way until the pickup and busbar soldering of one cell string array are completed on the bussing pickup portion, and then the cell string array can be discharged onto the glass plate.

By performing the layup pickup, alignment and conveying, bussing pickup, and busbar soldering on one module unit each time, the alignment and conveying portion does not need to wait for all the module units in the cell string array to be aligned before conveying; and the bussing portion does not need to wait for all the module units to be in place before soldering. The structures of the alignment and conveying portion and the bussing portion can be simplified, that is, the alignment and conveying portion and the bussing portion only need to be configured for the module unit to be conveyed, instead of being configured for all the module units. Accordingly, equipment costs can be greatly reduced, the area occupied by the equipment can be reduced, and the efficiency of layup and busbar soldering can be improved.

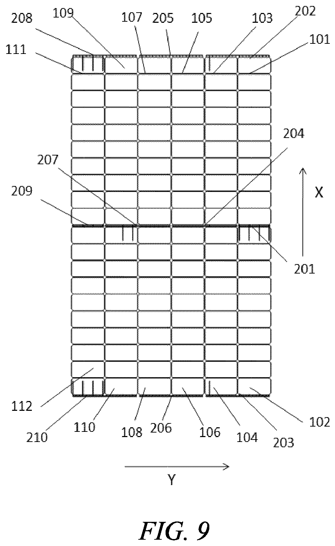

Taking a cell string array of a half-cell module shown in FIG. 9 as an example, the process of performing layup and bussing on one module unit each time in this embodiment will be described below.

The cell string array in FIG. 9 is formed by six module units arranged side by side in the width direction (the Y-axis direction as shown in the figure) of the cell strings, and each module unit comprises two cell strings arranged in line in the length direction (the X-axis direction as shown in the figure) of the cell strings. Specifically, a first module unit is formed by arranging a first cell string 101 and a second cell string 102, a second module unit is formed by arranging a third cell string 103 and a fourth cell string 104, a third module unit is formed by arranging a fifth cell string 105 and a sixth cell string 106, a fourth module unit is formed by arranging a seventh cell string 107 and an eighth cell string 108, a fifth module unit is formed by arranging a ninth cell string 109 and a tenth cell string 110, and a sixth module unit is formed by arranging an eleventh cell string 111 and a twelfth cell string 112.

Correspondingly, the bussing pickup portion 10 comprises twelve string pickup assemblies 1001 arranged in one-to-one correspondence with the twelve cell strings in the cell string array shown in FIG. 9, two string pickup assemblies 1001 in line with each other form one pickup unit, and each pickup unit is configured to pick up one module unit.

This process is exemplarily illustrated as follows: the layup pickup portion places a module unit on the alignment and conveying portion at intervals of the predetermined time, the alignment and conveying portion conveys the aligned module unit to the string pickup station at intervals of the predetermined time, the bussing pickup portion moves in a downstream direction by the predetermined distance at intervals of the predetermined time so as to drive a pickup unit corresponding to the module unit at the string pickup station to the string pickup station for picking up the module unit, while driving the pickup unit, which has already picked up a module unit, to the corresponding soldering station, and the bussing portion solders a busbar to the module unit at the soldering station. Specifically, the cooperative working process of the layup pickup portion, the alignment and conveying portion, the bussing pickup portion and the bussing portion is as follows.

In an initial state, a first pickup unit of the bussing pickup portion 10 is located at the string pickup station, the layup pickup portion places the first module unit, that is, the first cell string 101 and the second cell string 102, on the alignment and conveying portion, the alignment and conveying portion aligns the first cell string 101 and the second cell string 102 and then conveys the first module unit to the string pickup station, the first pickup unit of the bussing pickup portion 10 picks up the first cell string 101 and the second cell string 102 conveyed by the alignment and conveying portion, the bussing pickup portion 10 then moves in the downstream direction by the predetermined distance such that the first pickup unit moves to the soldering station, a second pickup unit moves to the string pickup station, and the bussing portion then solders a first middle busbar 201 to the marginal solder strips of the first cell string 101 and the second cell string 102 located at the soldering station.

After the first module unit is picked up by the bussing pickup portion 10, the alignment and conveying portion returns immediately to receive the second module unit, that is, the third cell string 103 and the fourth cell string 104, picked up by the layup pickup portion, and conveys the third cell string 103 and the fourth cell string 104 to the string pickup station after alignment, the second pickup unit of the bussing pickup portion picks up the third cell string 103 and the fourth cell string 104, the bussing pickup portion 10 then moves in the downstream direction by the predetermined distance such that the second pickup unit moves to the soldering station, a third pickup unit moves to the string pickup station, and the bussing portion then solders a first head busbar 202 and a first tail busbar 203 to the marginal solder strips of the first cell string 101, the second cell string 102, the third cell string 103 and the fourth cell string 104 located at the soldering station.

After the second module unit is picked up by the bussing pickup portion 10, the alignment and conveying portion returns immediately to receive the third module unit, that is, the fifth cell string 105 and the sixth cell string 106, picked up by the layup pickup portion, and conveys the fifth cell string 105 and the sixth cell string 106 to the string pickup station after alignment, the third pickup unit of the bussing pickup portion picks up the fifth cell string 105 and the sixth cell string 106, the bussing pickup portion 10 then moves in a downstream direction by the predetermined distance such that the third pickup unit moves to the soldering station, a fourth pickup unit moves to the string pickup station, and the bussing portion then solders a second middle busbar 204 to the marginal solder strips of the third cell string 103, the fourth cell string 104, the fifth cell string 105 and the sixth cell string 106 located at the soldering station.

After the third module unit is picked up by the bussing pickup portion 10, the alignment and conveying portion returns immediately to receive the fourth module unit, that is, the seventh cell string 107 and the eighth cell string 108, picked up by the layup pickup portion, conveys the seventh cell string 107 and the eighth cell string 108 to the string pickup station after alignment, the fourth pickup unit of the bussing pickup portion picks up the seventh cell string 107 and the eighth cell string 108, the bussing pickup portion 10 then moves in the downstream direction by the predetermined distance such that the fourth pickup unit moves to the soldering station, the fifth pickup unit moves to the string pickup station, and the bussing portion then solders a second head busbar 205 and a second tail busbar 206 to the marginal solder strips of the fifth cell string 105, the sixth cell string 106, the seventh cell string 107 and the eighth cell string 108 located at the soldering station.

After the fourth module unit is picked up by the bussing pickup portion 10, the alignment and conveying portion returns immediately to receive the fifth module unit, that is, the ninth cell string 109 and the tenth cell string 110, picked up by the layup pickup portion, and conveys the ninth cell string 109 and the tenth cell string 110 to the string pickup station after alignment, the fifth pickup unit of the bussing pickup portion picks up the ninth cell string 109 and the tenth cell string 110, the bussing pickup portion 10 then moves in the downstream direction by the predetermined distance such that the fifth pickup unit moves to the soldering station, a six pickup unit moves to the string pickup station, and the bussing portion then solders a third middle busbar 207 to the marginal solder strips of the seventh cell string 107, the eighth cell string 108, the ninth cell string 109 and the tenth cell string 110 located at the soldering station.

After the fifth module unit is picked up by the bussing pickup portion 10, the alignment and conveying portion returns immediately to receive the sixth module unit, that is, the eleventh cell string 111 and the twelfth cell string 112, picked up by the layup pickup portion, and conveys the eleventh cell string 111 and the twelfth cell string 112 to the string pickup station after alignment, the sixth pickup unit of the bussing pickup portion picks up the eleventh cell string 111 and the twelfth cell string 112, the bussing pickup portion 10 then moves in the downstream direction by the predetermined distance such that the sixth pickup unit moves to the soldering station, and the bussing portion then solders a third head busbar 208, a fourth middle busbar 209 and a third tail busbar 210 to the marginal solder strips of the ninth cell string 109, the tenth cell string 110, the eleventh cell string 111 and the twelfth cell string 112 located at the soldering station.

At this point, the layup and busbar soldering of the cell string array of one half-cell module are completed, and the bussing pickup portion then discharges the cell string array soldered with the busbars onto the glass plate.

In order to further improve the efficiency, the layup pickup portion may alternatively place four, six or a different number of cell strings on the alignment and conveying portion each time to form two, three or a different corresponding number of module units. Correspondingly, the alignment and conveying portion conveys a corresponding number of module units to the string pickup station each time, and the bussing pickup portion 10 moves a corresponding number of pickup units to the string pickup station and the soldering station during each time of movement. For example, the layup pickup portion places four cell strings, that is, two module units, on the alignment and conveying portion each time. In this case, the alignment and conveying portion conveys the two module units to the string pickup station each time, and during each time of movement, the bussing pickup portion moves two pickup units to the string pickup station while moving two adjacent pickup units to the soldering station.

Of course, the layup and bussing machine of the present disclosure is likewise suitable for layup and bussing of the full cell strings. In this case, in some implementations, the layup pickup portion places a cell string on the alignment and conveying portion each time, the alignment and conveying portion conveys, after completing the alignment of the cell string, the cell string to the string pickup station and provides the cell string to the string pickup assembly corresponding to the cell string on the bussing pickup portion; and the string pickup assembly picks up the cell string and then moves the cell string to the soldering station, meanwhile, an adjacent string pickup assembly behind the string pickup assembly moves to the string pickup station, and the bussing portion solders the busbar to the cell string at the soldering station. The layup and bussing process of the full-cell module is similar to the process of the aforementioned half-cell module, and will not be described in detail herein.

In some implementations, the bussing pickup portion 10 further comprises a stepping drive mechanism and a first mounting bracket. The first mounting bracket is connected to a movable end of the stepping drive mechanism, and the string pickup assemblies 1001 are jointly mounted on the first mounting bracket. The stepping drive mechanism is configured to drive, in a stepping manner, the string pickup assemblies 1001 to translate, so as to drive the string pickup assembly 1001 corresponding to a module unit at the string pickup station to the string pickup station for picking up the module unit, while driving the string pickup assembly 1001, which has already picked up a module unit, to the soldering station.

In some implementations, the layup pickup portion comprises a movement mechanism, a rotating mechanism and a pickup assembly. The rotating mechanism is connected to a driving end of the movement mechanism, and the pickup assembly is mounted on the rotating mechanism; the movement mechanism is configured to drive the pickup assembly to translate and lift so as to pick up a cell string; the rotating mechanism is configured to drive the pickup assembly to rotate so as to rotate the cell string until the layup requirements for positive and negative electrodes are met; and the movement mechanism is further configured to drive the pickup assembly to translate and lift so as to place the picked-up cell string on the alignment and conveying portion.

The movement mechanism may be a robotic arm or a truss capable of moving in X, Y, and Z directions. A suction cup group capable of sucking the cell string may be used as the pickup assembly.

During the layup of the cell strings, it is necessary to ensure that two adjacent cell strings arranged together side by side have opposite polarities at the same end in order to facilitate series soldering with the busbar. Therefore, the rotating mechanism is configured to control some of the picked-up cell strings to rotate in a plane, so as to ensure that two adjacent cell strings eventually arranged side by side have opposite polarities at the same end, and thus the layup requirements for positive and negative electrodes are met.

As shown in FIGS. 1 to 3, in some implementations, two layup pickup portions are provided, which are a first layup pickup portion 6 and a second layup pickup portion 7, respectively. The first layup pickup portion 6 is configured to place one of the cell strings of the module unit on the alignment and conveying portion, and the second layup pickup portion 7 is configured to place the other cell string in the module unit on the alignment and conveying portion. That is, when the layup and busbar soldering are performed on the half-cut cell strings, the first layup pickup portion 6 and the second layup pickup portion 7 synchronously place the two cell strings of the module unit on the alignment and conveying portion, thereby improving the layup efficiency of the module unit.

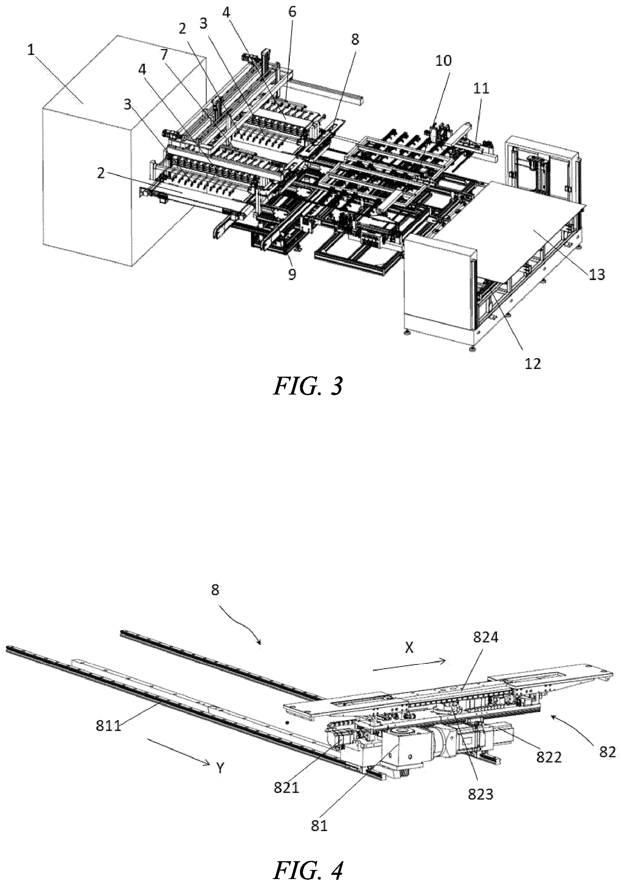

In some implementations, as shown in FIGS. 1 and 4, the alignment and conveying portion comprises a first alignment and conveying mechanism 8 and a second alignment and conveying mechanism 9 which are of the same structure. The first alignment and conveying mechanism 8 and the second alignment and conveying mechanism 9 are arranged in line in a first horizontal direction (the X direction as shown in FIG. 1). The first alignment and conveying mechanism 8 and the second alignment and conveying mechanism 9 are respectively configured to carry two cell strings of the module unit.

The first alignment and conveying mechanism 8 comprises a first translation drive mechanism 81 and at least one alignment platform 82 connected to a movable end of the first translation drive mechanism 81. In FIG. 4, one alignment platform 82 is connected to the movable end of the first translation drive mechanism 81, the alignment platform 82 is configured to carry a cell string and align the cell string, and when a plurality of alignment platforms 82 are connected to the movable end of the first translation drive mechanism 81, each alignment platform 82 is configured to carry one cell string and align the cell string. The first translation drive mechanism 81 is configured to drive each alignment platform 82 to translate along a slide rail 811, and the slide rail 811 is arranged in a second horizontal direction (the Y-axis direction as shown in FIG. 4) perpendicular to the first horizontal direction so as to convey the cell string carried on each alignment platform 82 to the string pickup station.

As described above, when the layup and busbar soldering are performed on the half-cut cell strings, if the layup pickup portion places one module unit on the alignment and conveying portion each time, the first alignment and conveying mechanism 8 and the second alignment and conveying mechanism 9 may be each provided with one alignment platform 82. The alignment platform 82 of the first alignment and conveying mechanism 8 is configured to place one of the cell strings of the module unit, and the alignment platform 82 of the second alignment and conveying mechanism 9 is configured to place the other cell string in the module unit. If the layup pickup portion places N module units on the alignment and conveying portion each time, where N is greater than 1, the first alignment and conveying mechanism 8 and the second alignment and conveying mechanism 9 are each provided with N alignment platforms 82.

In some implementations, the first layup pickup portion 6 places one of the cell strings of the module unit on the alignment platform 82 of the first alignment and conveying mechanism 8, and the second layup pickup portion 7 places the other cell string in the module unit on the alignment platform 82 of the second alignment and conveying mechanism 9.

Continuing to refer to FIG. 4, in some implementations, the alignment platform 82 comprises a second translation drive mechanism 821, a lifting drive mechanism 822, a rotation drive mechanism 823 and an alignment carrying plate 824. The second translation drive mechanism 821 is connected to the movable end of the first translation drive mechanism 81, the lifting drive mechanism 822 is connected to a movable end of the second translation drive mechanism 821, the rotation drive mechanism 823 is connected to a movable end of the lifting drive mechanism 822, and the alignment carrying plate 824 is connected to a movable end of the rotation drive mechanism 823. The alignment carrying plate 824 is configured to carry the cell string, the second translation drive mechanism 821 is configured to drive the alignment carrying plate 824 to translate in the first horizontal direction (the X direction in the figure), the lifting drive mechanism 822 is configured to drive the alignment carrying plate 824 to lift, and the rotation drive mechanism 823 is configured to drive the alignment carrying plate 824 to rotate in a horizontal plane.

By means of the cooperative driving of the first translation drive mechanism 81, the second translation drive mechanism 821 and the rotation drive mechanism 823, the alignment carrying plate 824 can be driven to implement the translation in the X and Y directions and the rotation in the horizontal directions, and accordingly it is possible to align the position of the cell string placed on the alignment carrying plate 824, and convey the aligned cell string to the string pickup station according to the layup position requirements. The lifting drive mechanism 822 can drive the alignment carrying plate 824 to ascend after the alignment platform moves to the string pickup station, so as to transfer the cell string to the corresponding string pickup assembly on the bussing pickup portion.

In some implementations, the first layup pickup portion 6 picks up one cell string, rotates the cell string according to the layup requirements for positive and negative electrodes, and then places the cell string on the alignment platform 82 of the first alignment and conveying mechanism 8, and meanwhile, the second layup pickup portion 7 picks up the other cell string, rotates the cell string according to the layup requirements for positive and negative electrodes, and then places the cell string on the alignment platform 82 of the second alignment and conveying mechanism 9. After aligning the corresponding cell strings respectively, the first alignment and conveying mechanism 8 and the second alignment and conveying mechanism 9 synchronously convey the two cell strings in the downstream direction until the cell strings are conveyed to predetermined positions of the string pickup station.

In some implementations, vision cameras are arranged above the first alignment and conveying mechanism 8 and the second alignment and conveying mechanism 9, the vision cameras are configured to capture the cell strings so as to obtain position information of the cell strings, and the first alignment and conveying mechanism 8 and the second alignment and conveying mechanism 9 align and convey the corresponding cell strings according to the position information of the corresponding cell strings obtained by the vision cameras.

In some implementations, the layup and bussing machine of the present disclosure further comprises a cell string supply portion. The cell string supply portion is configured to produce a cell string and provide the produced cell string to the layup pickup portion.

Continuing to refer to FIGS. 1 to 3, in some implementations, the cell string supply portion comprises a soldering stringer 1, a discharge conveyor line 2, a turnover mechanism 3 and a temporary storage mechanism 4. The soldering stringer 1 is configured to produce a cell string. The discharge conveyor line 2 is configured to output the cell string produced by the soldering stringer 1. The temporary storage mechanism 4 is arranged on a side of the discharge conveyor line 2, and the turnover mechanism 3 is configured to pick up the cell string from the discharge conveyor line 2, turn over the picked-up cell string by 180° and then place the cell string on the temporary storage mechanism 4. The layup pickup portion picks up the cell string from the temporary storage mechanism 4.

In some implementations, continuing to refer to FIGS. 1 to 3, the soldering stringer 1 is a dual-line soldering stringer with two cell string production lines. Correspondingly, discharge ends of the two cell string production lines are each provided with one discharge conveyor line 2 for outputting the cell string. The cell string output by one discharge conveyor line 2 is provided to the first layup pickup portion 6, and the cell string output by the other discharge conveyor line 2 is provided to the second layup pickup portion 7. By using the dual-line soldering stringer, dual supply of the cell strings is achieved, and the efficiency of supplying the cell strings is improved. When two discharge conveyor lines 2 are provided, two turnover mechanisms 3 and two temporary storage mechanisms 4 are also provided correspondingly. The two turnover mechanisms 3 respectively pick up the cell strings from the corresponding discharge conveyor lines 2 and temporarily store the picked-up cell strings in the corresponding temporary storage mechanisms 4.

Typically, a front side of the cell string produced by the soldering stringer faces up, and a back side of the cell string is required to face up during layup. By providing the turnover mechanisms 3, the cell string can be turned over by 180 degrees, the cell string can thus be directly turned over to reach a state in which the cell string is to be subjected to layup, and the pickup efficiency of the layup pickup portion on the downstream side is improved. Moreover, by providing the temporary storage mechanism 4, the temporary storage of the cell string produced by the soldering stringer 1 is achieved, to avoid waiting for layup caused by the inconsistency between the production speed of the soldering stringer 1 and the layup and pickup speed on the downstream side. For the dual-line soldering stringer, the provision of the temporary storage mechanisms can also avoid waiting for layup caused by the inconsistency between the production speeds of the two production lines. In addition, the turnover mechanism can pick up and turn over the cell string and then place the cell string directly on the temporary storage mechanism, without the need for an additional cell string gripper which picks up the turned-over cell string and then places the cell string on the temporary storage mechanism. The turnover and temporary storage of the cell string can be achieved by means of a single gripping and placement, facilitating the reduction of the fragmentation rate of the cells.

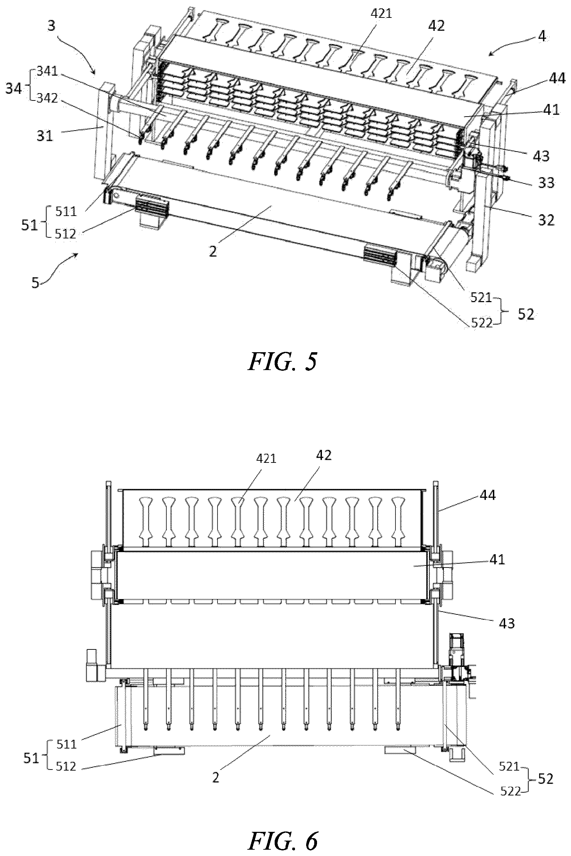

In some implementations, as shown in FIGS. 5 and 6, the turnover mechanism 3 comprises a first lifting drive module 31, a second lifting drive module 32, a turnover motor 33 and a turnover suction assembly 34. The turnover motor 33 is connected to a driving end of the second lifting drive module 32, a first end of the turnover suction assembly 34 is connected to a driving end of the first lifting drive module 31, and a second end of the turnover suction assembly 34 is connected to a driving end of the turnover motor 33. The first lifting drive module 31 and the second lifting drive module 32 cooperate with each other to drive the turnover suction assembly 34 to lift, and the turnover motor 33 is configured to drive the turnover suction assembly 34 to be turned over between the discharge conveyor line 2 and the temporary storage mechanism 4, so as to drive the turnover suction assembly 34 to suck the cell string from the discharge conveyor line 2 and turn over the sucked cell string to the temporary storage mechanism 4.

It can be seen that by means of the cooperation of the first lifting drive module 31, the second lifting drive module 32, the turnover motor 33 and the turnover suction assembly 34, the turnover mechanism 3 can pick up the cell string from the discharge conveyor line 2, turn over the cell string by 180 degrees and then temporarily store the cell string in the temporary storage mechanism 4.

Continuing to refer to FIGS. 5 and 6, in some implementations, the temporary storage mechanism 4 comprises a second mounting bracket 41, a plurality of carriers 42, a first carrier pushing mechanism 43 and a second carrier pushing mechanism 44. The plurality of carriers 42 are stacked on the second mounting bracket 41 in a vertical direction, and each carrier 42 is connected to the second mounting bracket 41 via a slide rail. The first carrier pushing mechanism 43 is configured to push one carrier 42 out of the second mounting bracket 41 toward a first side each time, so as to receive the cell string transferred by the turnover mechanism 3. The second carrier pushing mechanism 44 is configured to push one carrier 42 carrying the cell string out of the second mounting bracket 41 toward a second side each time, so as to provide the cell string 42 to the layup pickup portion.

By providing the plurality of carriers 42, the temporary storage mechanism 4 can implement the temporary storage of a plurality of cell strings. Moreover, the carriers 42 are each configured to be capable of extending out or retracting from two sides of the second mounting bracket 41. When extending out toward the first side, the carrier 42 receives the cell string transferred by the turnover mechanism 3, and when extending out toward the second side, the carrier 42 provides the cell string to the layup pickup portion, so that the storage and takeout of cell strings are achieved on the two sides without interfering with each other.

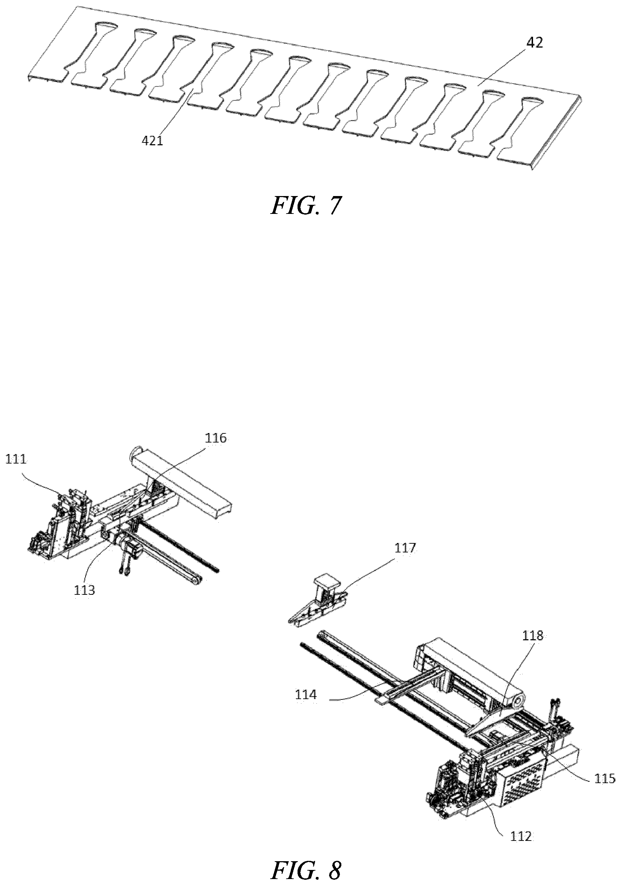

As shown in FIG. 5, optionally, the carriers 42 are each provided with an avoidance slot 421 for the turnover suction assembly 34 to pass through. After completing the turnover of the cell string, the turnover suction assembly 34 is located below the cell string. When the turnover suction assembly 34 drives the cell string to descend, the turnover suction assembly 34 passes through the avoidance slot 421, to place the turned-over cell string on the carrier 42. As shown in FIG. 7, a side of the avoidance slot 421 close to the turnover mechanism 3 is opened such that the turnover suction assembly 34 can pass through the avoidance slot 421 smoothly.

In an implementation, the turnover suction assembly 34 comprises a rotating shaft 341 and a plurality of suction members 342. A first end of the rotating shaft 341 is connected to the driving end of the first lifting drive module 31, and a second end of the rotating shaft 341 is connected to the driving end of the turnover motor 33. The plurality of suction members 342 are mounted side by side on the rotating shaft 341 in an extension direction of the rotating shaft 341. Correspondingly, the carriers 42 are each provided with avoidance slots 421 in one-to-one correspondence with the plurality of suction members 342.

The length direction of the cell string to be temporarily stored, which is located on the discharge conveyor line 2, is parallel to the rotating shaft 341, and when the turnover motor 33 drives the plurality of suction members 342 to be turned over toward the discharge conveyor line 2 by means of the rotating shaft 341, the plurality of suction members 342 suck the cell string from the discharge conveyor line 2. Then, the turnover motor 33 drives the plurality of suction members 342 to be turned over toward the temporary storage mechanism 4 by means of the rotating shaft 341. After the turnover, in the descending process, the plurality of suction members 342 pass through the corresponding avoidance slots 421 and then place the cell string sucked thereon on the carrier 42 of the temporary storage mechanism 4.

In some implementations, as shown in FIGS. 5 and 6, the cell string supply portion further comprises an EL testing mechanism 5. The EL testing mechanism 5 is arranged on the discharge conveyor line 2 and is configured to test the cell string output by the discharge conveyor line 2, and the turnover mechanism 3 is configured to pick up the cell string that has passed the test carried out by the EL testing mechanism from the discharge conveyor line 2. That is, only the cell string that has passed the test can undergo the following layup and soldering processes, and ultimately the pass rate of the photovoltaic module is ensured. Moreover, the EL testing mechanism 5 is provided directly on the discharge conveyor line 2, and can directly perform an EL test on the cell string on the discharge conveyor line 2, so that it is not necessary to grip the cell string away from the discharge conveyor line 2 for testing, to avoid the gripping and placement of the cell string, facilitating the reduction of the fragmentation rate of the cells.

In some implementations, the EL testing mechanism 5 comprises a first activation mechanism 51 and a second activation mechanism 52 which are arranged on the discharge conveyor line in a conveying direction of the discharge conveyor line, and an EL camera arranged above or below the discharge conveyor line 2. The cell string produced by the soldering stringer 1 is output by the discharge conveyor line 2, and when the cell string is conveyed by the discharge conveyor line 2 to reach a predetermined testing station, the discharge conveyor line 2 stops conveying. The first activation mechanism 51 and the second activation mechanism 52 respectively press a first end solder strip and a second end solder strip of the cell string so as to activate the cell string. After being activated, the cell string generates heat, and the temperature thereof rises. The EL camera acquires an infrared image of the activated cell string, and analyzes the infrared image so as to determine whether there are cells having defects such as damage and weak soldering in the cell string.

In some implementations, the first activation mechanism 51 comprises a first electrode plate 511 and a first electrode plate driving portion 512 which are connected to a positive electrode of a power supply. The first electrode plate driving portion 512 is mounted on a side of the discharge conveyor line 2, and the first electrode plate 511 is connected to a driving end of the first electrode plate driving portion 512. The second activation mechanism 52 comprises a second electrode plate 521 and a second electrode plate driving portion 522 which are connected to a negative electrode of the power supply. The second electrode plate driving portion 522 is mounted on a side of the discharge conveyor line 2, and the second electrode plate 521 is connected to a driving end of the second electrode plate driving portion 522.

When the cell string is conveyed to the testing station, the first electrode plate driving portion 512 drives the first electrode plate 511 to translate and lift, so as to press the first electrode plate 511 against the first end solder strip of the cell string. The second electrode plate driving portion 522 drives the second electrode plate 521 to translate and lift, so as to press the second electrode plate 521 against the second end solder strip of the cell string.

In an implementation, the first electrode plate driving portion 512 and the second electrode plate driving portion 522 are of the same structure. The first electrode plate driving portion 512 comprises two translation drive cylinders and two lifting drive cylinders. The two translation drive cylinders are respectively mounted on two sides of the discharge conveyor line 2, the two lifting drive cylinders are respectively mounted on driving ends of the two translation drive cylinders, and two ends of the first electrode plate 511 are respectively connected to driving ends of the two lifting drive cylinders, such that translation drive and lifting drive performed on the first electrode plate 511 are achieved.

In some implementations, the bussing portion further comprises a busbar preparation portion, a busbar handling portion, a busbar carrying portion and a soldering portion; the busbar preparation portion is configured to prepare a busbar; the busbar handling portion is configured to handle the busbar to the busbar carrying portion; the busbar carrying portion is configured to move the busbar to the position of a corresponding marginal solder strip; and the soldering portion is configured to solder the busbar carried by the busbar carrying portion to the marginal solder strip.

The busbar preparation portion achieves the preparation of the busbar, the busbar handling portion achieves the handling of the busbar from the preparation portion to the busbar carrying portion, the provision of the busbar carrying portion achieves the carrying, movement, and soldering support of the busbar, and the soldering portion achieves the soldering of the busbar to the marginal solder strips. The number of busbar preparation portions, the number of busbar handling portions, the number of busbar carrying portions and the number of soldering portions may be comprehensively considered according to the soldering efficiency and equipment costs. By providing the busbar preparation portion, the busbar handling portion, the busbar carrying portion and the soldering portion, when the busbar carrying portion and the soldering portion cooperate with each other to solder the busbar, the busbar preparation portion and the busbar handling portion can perform the preparation and handling of busbars simultaneously, and thus the bussing efficiency of the busbars is improved.

In some implementations, as shown in FIG. 8, the busbar soldering suitable for a half-cell module is illustrated. The busbar preparation portion comprises a head busbar preparation sub-portion 111 and a middle and tail busbar preparation sub-portion 112; the busbar handling portion comprises a first handling portion and a second handling sub-portion; the busbar carrying portion comprises a head busbar carrying sub-portion 113, a tail busbar carrying sub-portion 114, and a middle busbar carrying sub-portion 115; and the soldering portion comprises a head soldering sub-portion 116, a middle soldering sub-portion 117 and a tail soldering sub-portion 118. The head busbar preparation sub-portion 111 is configured to prepare a head busbar, the first handling portion is configured to handle the head busbar prepared by the head busbar preparation sub-portion 111 to the head busbar carrying sub-portion 113, the head busbar carrying sub-portion 113 is configured to move the head busbar to below a head marginal solder strip of the module unit, and the head soldering sub-portion 116 is configured to solder the head busbar to the head marginal solder strip of the module unit. The middle and tail busbar preparation sub-portion 112 is configured to prepare a middle busbar and a tail busbar, a second handling mechanism is configured to carry the middle busbar and the tail busbar prepared by the middle and tail busbar preparation sub-portion 112 to the middle busbar carrying sub-portion 115 and the tail busbar carrying sub-portion 114 respectively, the middle busbar carrying sub-portion 115 moves the middle busbar to below a middle marginal solder strip of the module unit, the middle soldering sub-portion 117 is configured to solder the middle busbar to the middle marginal solder strip of the module unit, the tail busbar carrying sub-portion 114 moves the tail busbar to below a tail marginal solder strip of the module unit, and the tail soldering sub-portion 118 is configured to solder the tail busbar to the tail marginal solder strip of the module unit.

In an implementation, the head busbar preparation sub-portion 111 and the middle and tail busbar preparation sub-portion 112 each comprise a roll carrying device for carrying a busbar roll, a cutter for cutting off the busbar, a pulling chuck for pulling the busbar, and a supporting table for carrying the busbar; and the busbar roll is placed on the roll carrying device, the busbar on the busbar roll is pulled out from the busbar roll and passes through the middle of the cutter, the pulling chuck is configured to pull the busbar, the cutter is configured to cut off the busbar pulled to a predetermined position by the chuck, and the pulling chuck then pulls the busbar and places the busbar on the supporting table for carrying the busbar.

The first handling sub-portion and the second handling sub-portion each comprise a busbar suction cup and a handling drive device. The handling drive device drives the busbar suction cup to suck the busbar on the busbar supporting table and then handle the busbar to the corresponding busbar carrying portion. The handling drive device may be a motor module which is composed of a lifting motor and a translation motor and capable of driving the busbar suction cup to lift and move horizontally, or may be a cylinder module which is composed of a lifting cylinder and a translation cylinder and capable of driving the busbar to lift and move horizontally.

In some implementations, as shown in FIGS. 1 to 3, the layup and bussing machine of the present disclosure further comprises a glass plate conveyor line 12. The glass plate conveyor line 12 is arranged below the alignment and conveying portion and the bussing portion 11 and has the same conveying direction as the alignment and conveying portion, and the glass plate conveyor line is configured to convey a glass plate to a discharging station downstream of the soldering station. After the soldering of the busbar to the cell strings picked up by the string pickup assemblies 1001 is completed, the bussing pickup portion 10 discharges the cell strings picked up by the string pickup assemblies 1001 onto the glass plate 13 of the discharging station.

The present disclosure has been described in sufficient detail with certain particularities above. Those skilled in the art should understand that the description of the embodiments is only exemplary, and all changes made without departing from the true spirit and scope of the present disclosure should fall within the scope of protection of the present disclosure. The scope of protection claimed by the present disclosure is defined by the claims, rather than by the above description of the embodiments.

## Claims

1. A layup and bussing machine configured to perform layup and busbar soldering on cell strings according to a cell string array in a photovoltaic module, the layup and bussing machine comprising a layup pickup portion, an alignment and conveying portion, a bussing pickup portion and a bussing portion, wherein
the layup pickup portion is arranged upstream of the alignment and conveying portion, and the layup pickup portion is configured to pick up a cell string and place the cell string on the alignment and conveying portion according to layup requirements for positive and negative electrodes;
the alignment and conveying portion is configured to receive and align the cell string placed by the layup pickup portion;
the bussing pickup portion comprises string pickup assemblies arranged in one-to-one correspondence with the cell strings of the cell string array; the alignment and conveying portion is further configured to convey the aligned cell string to a string pickup station according to layup position requirements, and the bussing pickup portion moves to drive a string pickup assembly corresponding to the cell string at the string pickup station to move to the string pickup station for picking up the cell string;
the bussing pickup portion moves to drive the string pickup assembly, which has picked up the cell string, to a soldering station, and the bussing portion solders a busbar to marginal solder strips at end portions of the cell string located at the soldering station; and
the bussing pickup portion is further configured to move so as to lay the cell strings picked up by the string pickup assemblies on a glass plate after the soldering of the busbar to the cell strings picked up by the string pickup assemblies is completed.

2. The layup and bussing machine of claim 1, wherein the layup pickup portion places at least one module unit on the alignment and conveying portion at a predetermined time interval, each module unit comprising two cell strings arranged in line in a length direction of the cell strings, and a plurality of module units being arranged side by side in a width direction of the cell strings to form the cell string array;
the alignment and conveying portion conveys an aligned module unit to the string pickup station at a predetermined time interval; and
the bussing pickup portion moves in a downstream direction by a predetermined distance at a predetermined time interval, so as to drive the string pickup assembly corresponding to the module unit at the string pickup station to the string pickup station for picking up the module unit, while driving the string pickup assembly, which has already picked up a module unit, to the soldering station.

3. The layup and bussing machine of claim 2, wherein the layup pickup portion comprises a movement mechanism, a rotating mechanism, and a pickup assembly, wherein
the rotating mechanism is connected to a driving end of the movement mechanism, and the pickup assembly is mounted on the rotating mechanism;
the movement mechanism is configured to drive the pickup assembly to translate and lift so as to pick up a cell string;
the rotating mechanism is configured to drive the pickup assembly to rotate so as to rotate the cell string until the layup requirements for positive and negative electrodes are met; and
the movement mechanism is further configured to drive the pickup assembly to translate and lift so as to place the picked-up cell string on the alignment and conveying portion.

4. The layup and bussing machine of claim 3, wherein two layup pickup portions are provided, which are a first layup pickup portion and a second layup pickup portion, respectively, wherein
the first layup pickup portion is configured to place one of the cell strings of the module unit on the alignment and conveying portion, and
the second layup pickup portion is configured to place the other cell string of the module unit on the alignment and conveying portion.

5. The layup and bussing machine of claim 2, wherein the alignment and conveying portion comprises a first alignment and conveying mechanism and a second alignment and conveying mechanism which are of the same structure, wherein the first alignment and conveying mechanism and the second alignment and conveying mechanism are arranged in line in a first horizontal direction; the first alignment and conveying mechanism and the second alignment and conveying mechanism are respectively configured to carry the two cell strings of the module unit;
the first alignment and conveying mechanism comprises a first translation drive mechanism and at least one alignment platform connected to a movable end of the first translation drive mechanism, wherein
the alignment platform is configured to carry one cell string and align the cell string; and
the first translation drive mechanism is configured to drive the alignment platform to translate in a second horizontal direction perpendicular to the first horizontal direction, so as to convey the cell string carried on the alignment platform to the string pickup station.

6. The layup and bussing machine of claim 5, wherein the alignment platform comprises a second translation drive mechanism, a lifting drive mechanism, a rotation drive mechanism, and an alignment carrying plate, wherein
the second translation drive mechanism is connected to the movable end of the first translation drive mechanism, the lifting drive mechanism is connected to a movable end of the second translation drive mechanism, the rotation drive mechanism is connected to a movable end of the lifting drive mechanism, and the alignment carrying plate is connected to a movable end of the rotation drive mechanism; and
the alignment carrying plate is configured to carry the cell string, the second translation drive mechanism is configured to drive the alignment carrying plate to translate in the first horizontal direction, the lifting drive mechanism is configured to drive the alignment carrying plate to lift, and the rotation drive mechanism is configured to drive the alignment carrying plate to rotate in a horizontal plane.

7. The layup and bussing machine of claim 2, wherein the bussing pickup portion further comprises a stepping drive mechanism and a first mounting bracket, wherein
the first mounting bracket is connected to a movable end of the stepping drive mechanism, and the string pickup assemblies are jointly mounted on the first mounting bracket; and
the stepping drive mechanism is configured to drive, in a stepping manner, the string pickup assemblies to translate, so as to drive the string pickup assembly corresponding to a module unit at the string pickup station to the string pickup station for picking up the module unit, while driving the string pickup assembly, which has already picked up a module unit, to the soldering station.

8. The layup and bussing machine of claim 1 or 2, further comprising a cell string supply portion, wherein the cell string supply portion is configured to produce a cell string and provide the produced cell string to the layup pickup portion.

9. The layup and bussing machine of claim 8, wherein the cell string supply portion comprises a soldering stringer, a discharge conveyor line, a turnover mechanism, and a temporary storage mechanism, wherein
the soldering stringer is configured to produce a cell string;
the discharge conveyor line is configured to output the cell string produced by the soldering stringer;
the temporary storage mechanism is arranged on a side of the discharge conveyor line, and the turnover mechanism is configured to pick up the cell string from the discharge conveyor line, turn over the picked-up cell string by 180° and then place the cell string on the temporary storage mechanism; and
the layup pickup portion picks up the cell string from the temporary storage mechanism.

10. The layup and bussing machine of claim 9, wherein the cell string supply portion further comprises an EL testing mechanism, the EL testing mechanism is arranged on the discharge conveyor line and is configured to test the cell string output by the discharge conveyor line, and the turnover mechanism is configured to pick up the cell string that has passed the test carried out by the EL testing mechanism from the discharge conveyor line.

11. The layup and bussing machine of claim 10, wherein the EL testing mechanism comprises a first activation mechanism and a second activation mechanism which are arranged on the discharge conveyor line in a conveying direction of the discharge conveyor line, and an EL camera arranged above or below the discharge conveyor line;
the first activation mechanism and the second activation mechanism are configured to activate the cell string located on the discharge conveyor line from two ends; and
the EL camera is configured to acquire an infrared image of the activated cell string so as to test the cell string.

12. The layup and bussing machine of claim 9, wherein the turnover mechanism comprises a first lifting drive module, a second lifting drive module, a turnover motor, and a turnover suction assembly, wherein
the turnover motor is connected to a driving end of the second lifting drive module;
a first end of the turnover suction assembly is connected to a driving end of the first lifting drive module, and a second end of the turnover suction assembly is connected to a driving end of the turnover motor; and
the first lifting drive module and the second lifting drive module cooperate with each other to drive the turnover suction assembly to lift, and the turnover motor is configured to drive the turnover suction assembly to be turned over between the discharge conveyor line and the temporary storage mechanism, so as to drive the turnover suction assembly to suck the cell string from the discharge conveyor line and turn over the sucked cell string to the temporary storage mechanism.

13. The layup and bussing machine of claim 9, wherein the temporary storage mechanism comprises a second mounting bracket, a plurality of carriers, a first carrier pushing mechanism and a second carrier pushing mechanism, wherein
the plurality of carriers are stacked on the second mounting bracket in a vertical direction, and each carrier is connected to the second mounting bracket via a slide rail;
the first carrier pushing mechanism is configured to push one carrier out of the second mounting bracket toward a first side each time, so as to receive the cell string transferred by the turnover mechanism; and
the second carrier pushing mechanism is configured to push one carrier carrying the cell string out of the second mounting bracket toward a second side each time, so as to provide the cell string to the layup pickup portion.

14. The layup and bussing machine of claim 1 or 2, wherein the bussing portion comprises a busbar preparation portion, a busbar handling portion, a busbar carrying portion, and a soldering portion;
the busbar preparation portion is configured to prepare a busbar;
the busbar handling portion is configured to handle the busbar to the busbar carrying portion;
the busbar carrying portion is configured to move the busbar to the position of a corresponding marginal solder strip; and
the soldering portion is configured to solder the busbar carried by the busbar carrying portion to the marginal solder strip.

15. The layup and bussing machine of claim 1 or 2, further comprising a glass plate conveyor line, wherein
the glass plate conveyor line is arranged below the alignment and conveying portion and the bussing portion and has the same conveying direction as the alignment and conveying portion, and the glass plate conveyor line is configured to convey a glass plate to a discharging station downstream of the soldering station; and
after the soldering of the busbar to the cell strings picked up by the string pickup assemblies is completed, the bussing pickup portion discharges the cell strings picked up by the string pickup assemblies onto the glass plate at the discharging station.
